# EUROPEAN PATENT APPLICATION

(11) **EP 2 866 121 A1**
(43) Date of publication of application: **29.04.2015**
(21) Application number: 14190646.1
(22) Date of filing: 28.10.2014
(51) Int. Cl.: G06F 1/16, G06F 21/35, G06K 7/10

(54) **Portable electronic device case, folio, and dock**

(30) Priority: 28.10.2013 US 201361896303 P; 07.01.2014 US 201461924284 P
(71) Applicant: Acco Brands Corporation, Lake Zurich, IL 60047-8997 (US)
(72) Inventor: Robinson, Todd C., San Mateo, CA 94402 (US); Kao, James, Newark, CA 94560 (US); Weaver, Adam S., Jackson, CA 95642 (US); Marshall, Barry, Santa Clara, CA 95054 (US)
(74) Representative: EP&C

(57) **Abstract**

A system for use with a portable electronic device, in particular a tablet computer, includes a case having a body configured to receive the portable electronic device, a first attachment structure formed on the body, and a second attachment structure formed on the body. The system also includes a folio having a cover and an attachment member. The attachment member is engageable with the first attachment structure of the case to selectively attach the case to the folio. The system further includes a dock having a housing and a lock mechanism supported by the housing. The lock mechanism is engageable with the second attachment structure of the case to selectively attach the case to the dock.

## Description

### FIELD OF THE INVENTION

The present invention relates to cases, folios, and docks for use with portable electronic devices, such as tablet computers.

### SUMMARY

The invention relates in particular to a system for use with a portable electronic device. The system includes a case having a body configured to receive the portable electronic device, a first attachment structure formed on the body, and a second attachment structure formed on the body. The system also includes a folio having a cover and an attachment member. The attachment member is engageable with the first attachment structure of the case to selectively attach the case to the folio. The system further includes a dock having a housing and a lock mechanism supported by the housing. The lock mechanism is engageable with the second attachment structure of the case to selectively attach the case to the dock.

The system according to the invention includes a case that receives the portable electronic device, a folio that selectively attaches to the case, and a dock that alternately selectively attaches to the case. The case advantageously is usable independently of the folio and the dock to help protect the portable electronic device. The case is also usable with the folio to provide a cover for the portable electronic device. The case is alternatively usable with the dock to provide a docking station for the portable electronic device.

In a possible embodiment of the system according to the invention the first attachment structure is spaced apart from the second attachment structure.

In a possible embodiment of the system according to the invention the first attachment structure includes a keyhole-shaped aperture, wherein a portion of the attachment member of the folio is received in the keyhole-shaped aperture.

In a possible embodiment of the system according to the invention the second attachment structure includes an aperture, wherein the lock mechanism includes a projection that is selectively moved into the aperture to secure the case to the dock.

Preferably, the second attachment structure further includes a guide slot, and the housing of the dock includes a rail that is received in the guide slot to facilitate aligning the aperture in the case with the projection of the lock mechanism.

In a further embodiment the dock includes an actuator supported by the housing, wherein the actuator is operable to move the projection relative to the case.

In a possible embodiment of the system according to the invention the body of the case includes a front portion and a back portion, wherein the front portion defines an opening through which a screen of the portable electronic device is accessible, and wherein the first and second attachment structures are formed on the back portion.

In a possible embodiment of the system according to the invention the cover of the folio includes a front cover and a back cover pivotally coupled to the front cover.

Preferably, the attachment member of the folio includes a rigid bar coupled to the back cover, and wherein the rigid bar extends across a portion of the case.

Preferably the front cover and the back cover of the folio are foldable to form a stand for the case.

In a possible embodiment of the system according to the invention the folio further includes a keyboard that is at least partially supported by the cover.

In a possible embodiment of the system according to the invention the housing of the dock defines a slot that receives a portion of the case.

In a possible embodiment of the system according to the invention the dock further includes a connector supported by the housing, and wherein the connector is configured to engage a port of the portable electronic device to electrically connect the portable electronic device to the dock.

In a preferred embodiment the system according to the invention is in particular used with a tablet computer.

The invention also relates to a case for a portable electronic device, such as a tablet computer. The case includes a body configured to receive the portable electronic device. The case also includes a first attachment structure formed on the body. The first attachment structure is configured to engage a folio to selectively attach the case to the folio. The case further includes a second attachment structure formed on the body. The second attachment structure is configured to engage a dock to selectively attach the case to the dock.

The case according to the invention is advantageously usable independently of the folio and the dock to help protect the portable electronic device. The case is also usable with the folio to provide a cover for the portable electronic device. The case is alternatively usable with the dock to provide a docking station for the portable electronic device.

In a possible embodiment of the case according to the invention the first attachment structure is spaced apart from the second attachment structure.

In a possible embodiment the case according to the invention the body includes a front portion and a back portion, wherein the front portion defines an opening through which a screen of the portable electronic device is accessible, and wherein the first and second attachment structures are formed on the back portion.

The first attachment structure may include two keyhole-shaped apertures formed in the back portion of the body.

The second attachment structure may include two apertures formed in the back portion of the body.

The invention also provides a docking system for a portable electronic device. The docking system includes a dock having a housing and a lock mechanism supported by the housing. The housing is configured to couple to the portable electronic device. The lock mechanism is operable to secure the portable electronic device to the housing. The docking system also includes a wireless key operable to communicate with the dock and an actuator coupled to the lock mechanism. The actuator is operable to disengage the lock mechanism to release the portable electronic device from the housing when the wireless key communicates with the dock.

The invention furthermore provides a method of using a dock for a portable electronic device. The dock includes a housing and lock mechanism supported by the housing. The method includes coupling the portable electronic device to the housing, securing the portable electronic device to the housing with the lock mechanism, communicating, by a wireless key, with the dock, and actuating an actuator to disengage the lock mechanism to release the portable electronic device from the housing when the wireless key communicates with the dock.

Other aspects of the invention will become apparent by consideration of the detailed description and accompanying drawings.

### BRIEF DESCRIPTION OF THE DRAWINGS

Fig. 1 illustrates a system for protecting and securing a portable electronic device, the system includes a case, a folio, and a dock.
Fig. 2 is a front perspective view of the case.
Fig. 3 is a rear perspective view of the case.
Fig. 4 is a front perspective view of the case attached to the folio, the folio being in a stand position.
Fig. 5 is a rear perspective view of the case attached to the folio while in the stand position.
Fig. 6 is a front perspective view of the case attached to the folio, the folio being in a closed position.
Fig. 7 is a rear perspective view of the case attached to the folio while in the closed position.
Fig. 8 is a front perspective view of the case attached to the folio while in the stand position, the folio including a keyboard.
Fig. 9 is a front perspective view of the case attached to the dock.
Fig. 10 is a front perspective view of the dock without the case.
Fig. 11 is a rear perspective view of the dock.
Fig. 12 is a top view of the dock.
Fig. 13 is a rear perspective view of the dock with a portion of a housing removed to show internal components of the dock.
Fig. 14 is a side view of the dock showing the case being inserted into the dock.
Fig. 15 is a side view of the dock with the case inserted into the dock.
Fig. 16 is a side, cross-sectional view of the dock taken along section line 16-16 of Fig. 9 and showing a lock mechanism of the dock in an engaged position with the case.
Fig. 17 is a side, cross-sectional view of the dock taken along section line 16-16 of Fig. 9 and showing the lock mechanism of the dock in a disengaged position with the case.
Fig. 18 is a flowchart depicting operation of the lock mechanism of the dock.
Fig. 19 is a flowchart depicting operation of a wireless key for use with the lock mechanism of the dock.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. As used herein, "couple" and "engage" (and variations thereof) can refer to direct or indirect couplings and engagements.

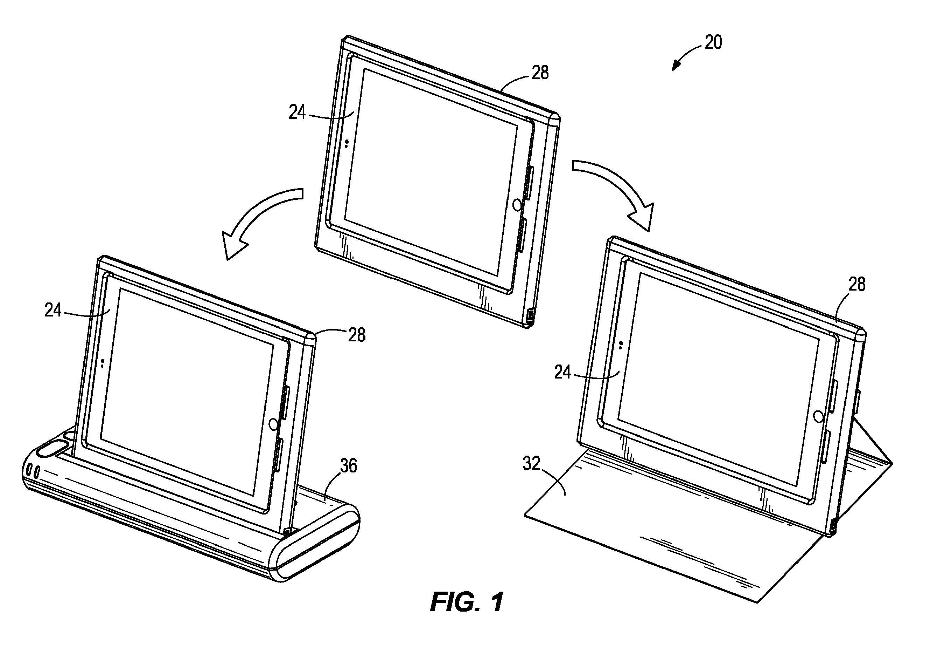

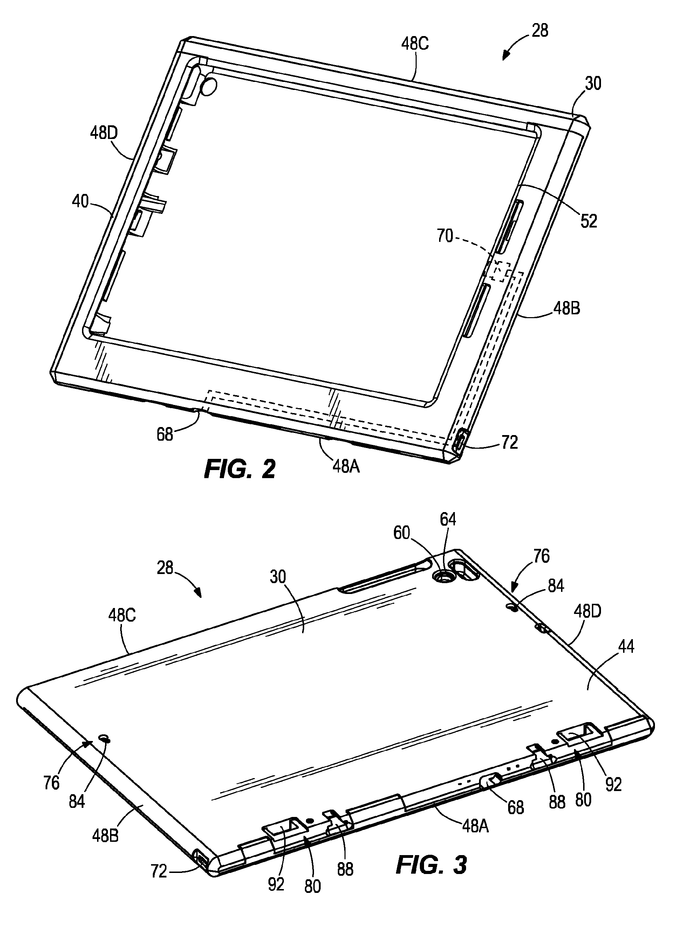

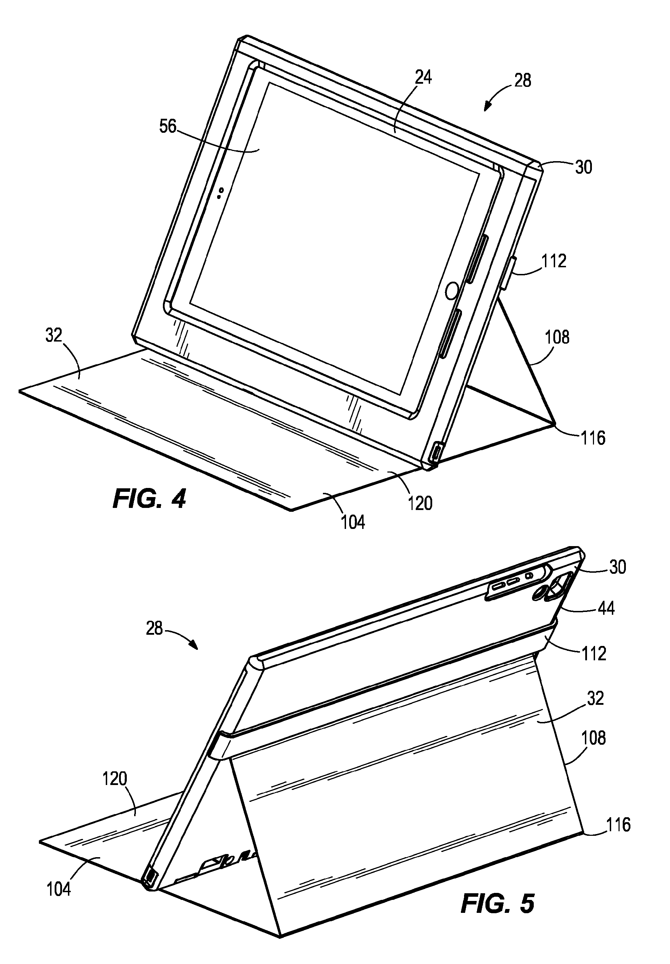

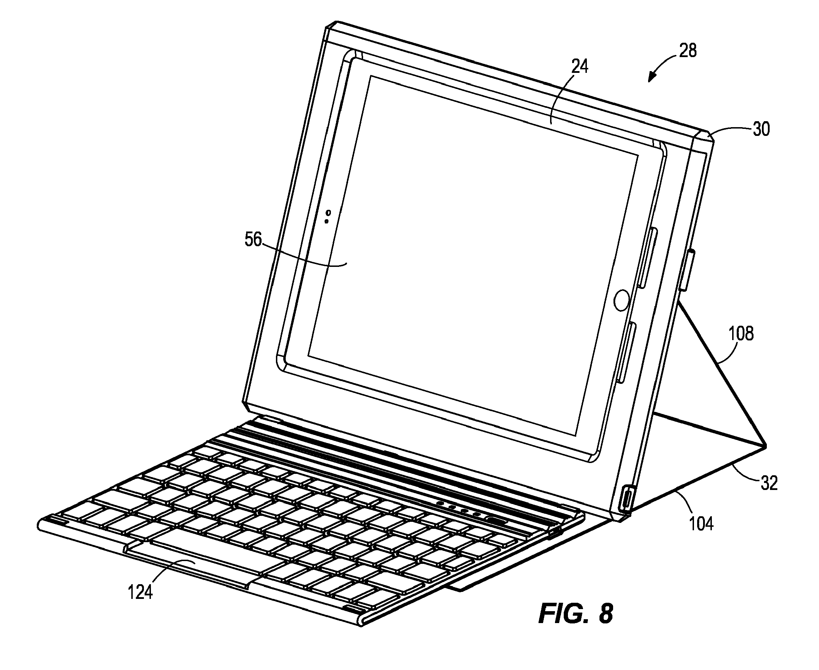

Fig. 1 illustrates a system 20 for protecting and securing a portable electronic device 24. The portable electronic device 24 is, for example, a tablet computer, such as a Galaxy Tab® sold by Samsung or an iPad® sold by Apple. The portable electronic device 24 may alternatively be a smartphone, an eReader, or the like. The illustrated system 20 includes a case 28 that receives the portable electronic device 24, a folio 32 that selectively attaches to the case 28, and a dock 36 that alternately selectively attaches to the case 28. In the illustrated embodiment, the case 28 is usable independently of the folio 32 and the dock 36 to help protect the portable electronic device 24, is usable with the folio 32 to provide a cover for the portable electronic device 24, or is usable with the dock 36 to provide a docking station for the portable electronic device 24. Figs. 2 and 3 illustrate the case 28 in more detail. The case 28 includes a body 30 configured to receive the portable electronic device 24 (Fig. 1). The body 30 has a front portion 40 and a back portion 44. The illustrated front and back portions 40, 44 connect together in a clamshell-type manner to at least partially enclose the portable electronic device 24. When connected together, the front and back portions 40, 44 form four sidewalls 48A-D extending around a perimeter of the portable electronic device. The front portion 40 defines an opening 52 through which a screen 56 (Figs. 4 and 8) of the portable electronic device 24 is visible and accessible. The back portion 44 extends across and covers a backside of the portable electronic device 24. In the illustrated embodiment, the back portion 44 defines an aperture 60 through which a camera 64 of the device 24 is accessible. The back portion 44 may define additional apertures, openings, or slots to access other components of the device 24.

The sidewalls 48A-D define slots or openings to access various components of the device 24. For example, the illustrated sidewalls 48A-D define a port 68 (e.g., a charging port) that connects to the device 24. As shown in Fig. 2, the charging port 68 is coupled to a pass-through connector 70. The pass-through connector 70 is housed between the front and back portions 40, 44 of the case 28 and connects to a charging port of the portable electronic device 24. The pass-through connector 70 provides access to the charging port of the portable electronic device 24 via the charging port 68 in the case 28 when the device 24 is positioned within the case 28. The illustrated sidewalls 48A-D also include a lock slot 72 that is configured to receive a locking head of a cable lock, such as a MicroSaver® lock sold by Kensington. The cable lock is operable to secure the case 28 to an immovable object, such as a desk, table, chair, wall, or the like. In other embodiments, the port 68 and/or the lock slot 72 may be located elsewhere on the case 28.

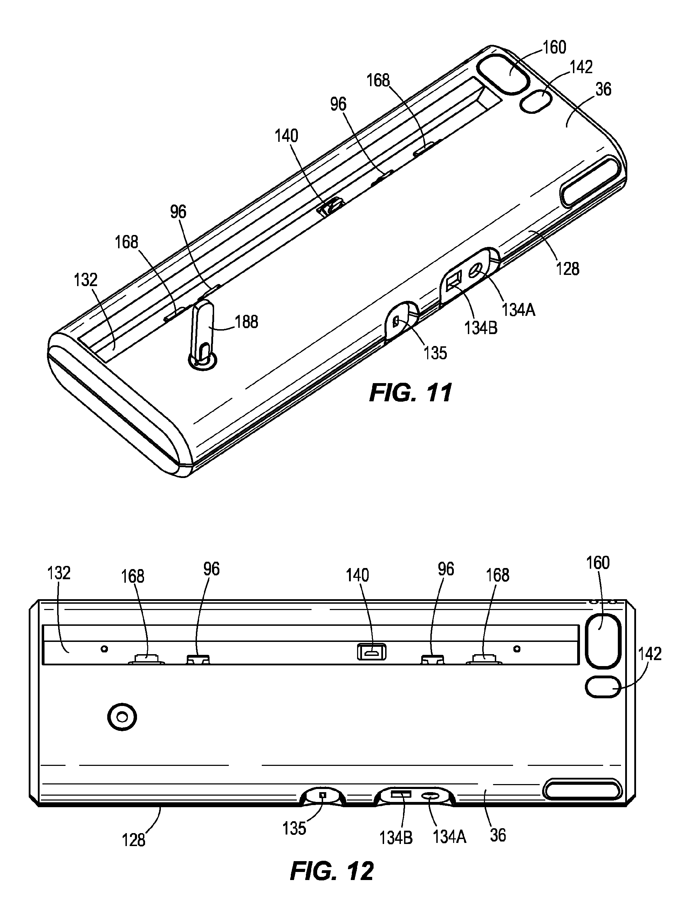

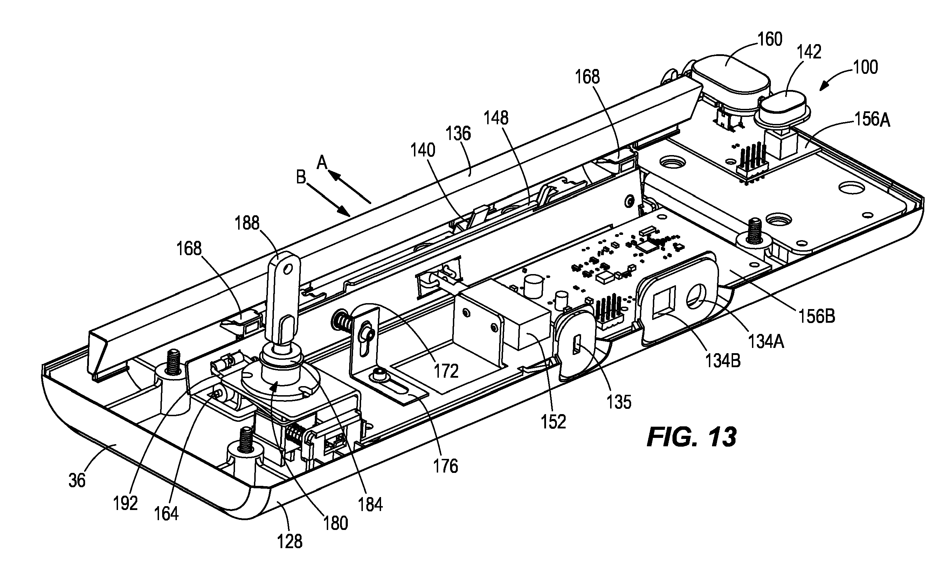

As shown in Fig. 3, the case 28 also includes two attachment structures 76, 80 formed in the back portion 44. The first attachment structure 76 includes two keyhole-shaped apertures 84 formed adjacent opposing sidewalls 48B, 48D of the case 28. The apertures 84 are configured to receive projections extending from the folio 32 (Figs. 4-7) to selectively attach the case 28 to the folio 32. The second attachment structure 80 includes two guide slots 88 and two rectangular apertures 92. The illustrated guide slots 88 are located adjacent the lower sidewall 48A of the case 28. The slots 88 are configured to receive guide rails 96 (Figs. 11-12) extending from the dock 36 to help properly align the case 28 on the dock 36. The illustrated apertures 92 are spaced slightly apart from the lower sidewall 48A of the case 28. The apertures 92 are configured to receive a lock mechanism 100 (Fig. 13) of the dock 36 to selectively secure the case 28 to the dock 36. Although each of the illustrated attachment structures 76, 80 includes two or more apertures, in other embodiments each attachment structure 76, 80 may include a single aperture or other suitable connecting feature.

Figs. 4-7 illustrate the case 28 attached to the folio 32. The folio 32 includes a front cover 104, a back cover 108, and an attachment member 112. The front cover 104 is attached to the back cover 108 at a hinge 116 so that the front cover 104 can move (e.g., pivot) relative to the back cover 108. The attachment member 112 is coupled to an edge of the back cover 108 opposite the front cover 104. The attachment member 112 is configured to extend across the case 28 and engage the two keyhole-shaped apertures 84 (Fig. 3) of the first attachment structure 76. The attachment member 112 and the apertures 84 allow the folio 32 to be selectively and releaseably attached to the case 28. In some embodiments, the front and back covers 104, 108 may be composed of a relatively soft and flexible material, such as fabric, and the attachment member 112 may be composed of a relatively rigid material, such as hard plastic. In other embodiments, the covers 104, 108 and the attachment member 112 may be formed of other suitable materials.

As shown in Figs. 4 and 5, the front and back covers 104, 108 may be folded to form a triangular stand. When in a stand position, the folio 32 can support the case 28, and thereby the portable electronic device 24, at multiple viewing angles. The lower sidewall 48A of the case 28 engages an inner surface 120 of the front cover 104 to support the case 28 and the portable electronic device 24 at the different viewing angles.

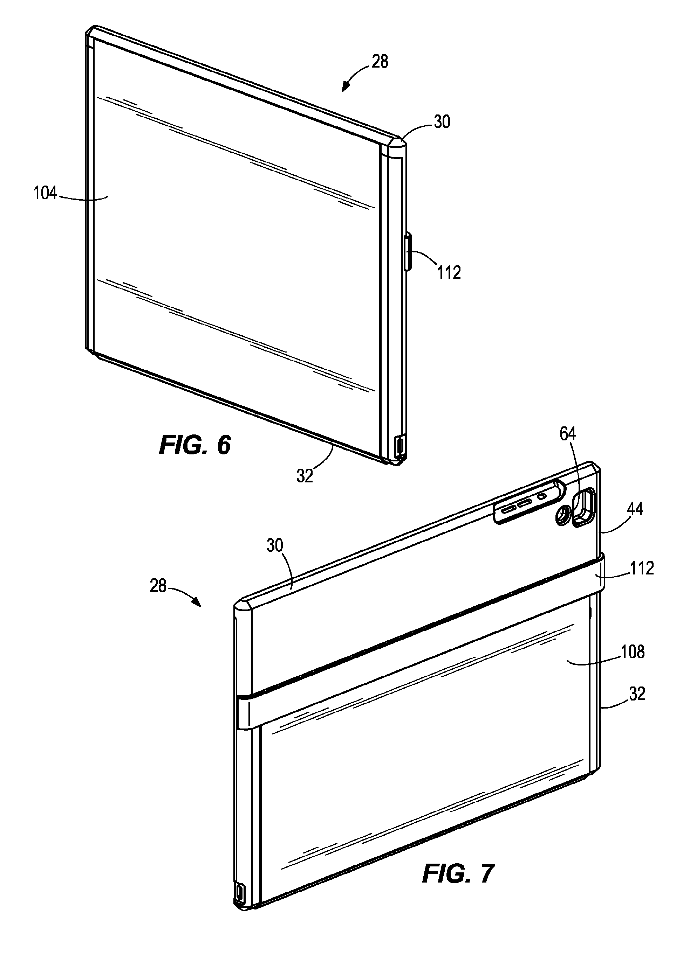

As shown in Figs. 6 and 7, the front and back covers 104, 108 may also be folded to a closed position to surround the case 28. When in the closed position, the front cover 104 extends across the opening 52 in the case 28 to cover and protect the screen 56 of the portable electronic device 24.

In some embodiments, such as the embodiment shown in Fig. 8, the folio 32 may also include a keyboard 124. The illustrated keyboard 124 is a wireless keyboard that communicates with the portable electronic device 24 in the case 28 via a short-range network (e.g., via Bluetooth). The keyboard 124 magnetically couples to the inner surface 120 of the front cover 104 and is adjustable (i.e., movable along the inner surface 120) relative to the front cover 104. The keyboard 124 also engages the lower sidewall 48A of the case 28 to inhibit the case 28 from sliding along the front cover 120. Alternatively, the lower sidewall 48A of the case 28 may rest directly on top of the keyboard 124 to achieve a desired viewing angle of the portable electronic device 24.

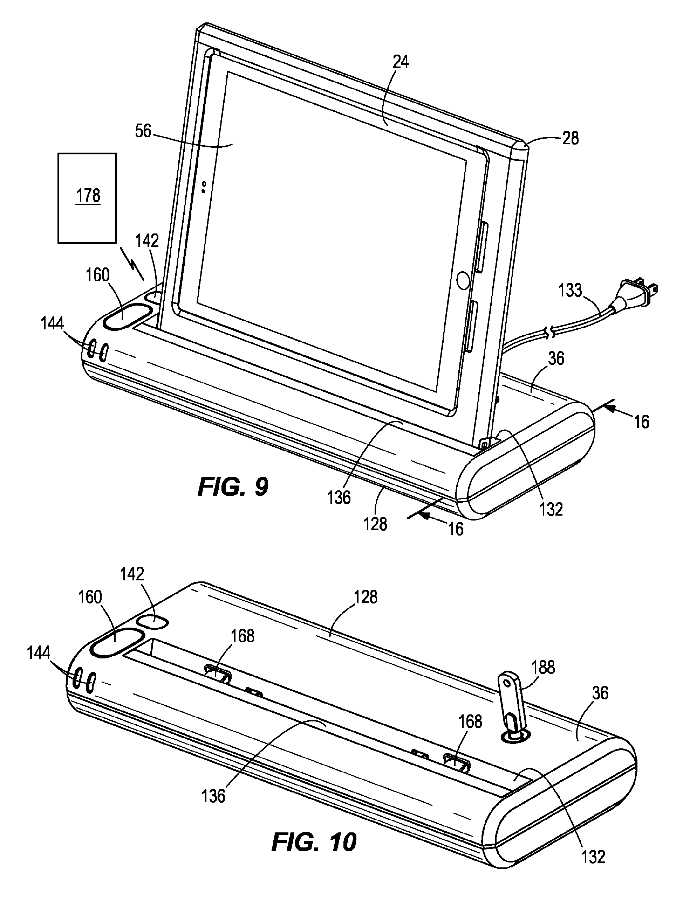

Fig. 9 illustrates the portable electronic device 24 attached to the dock 36. The dock 36, or stand, includes a housing 128. The housing 128 is configured to couple to the portable electronic device 24. When coupled together, the illustrated housing 128 also supports the device 24. In the illustrated embodiment, the housing 128 defines a slot 132 (Fig. 10). The slot 132 receives a lower portion of the case 28 to connect the case 28 to the dock 36. When the case 28 is received in the slot 132, the dock 36 is operable to secure the case 28, and thereby the portable electronic device 24, to the housing 128 using the lock mechanism 100 (Fig. 13).

Although the following description refers to the dock 36 engaging the case 28, in some embodiments, the dock 36 may directly engage the portable electronic device 24. In other words, the case 28 may be omitted, and lock mechanism 100 (Fig. 13) of the dock 36 may be configured to directly engage surfaces of or apertures formed in the portable electronic device 24 to secure the device 24 to the housing 128. For purposes of the specification and appended claims (and unless otherwise explicitly specified), "portable electronic device" can refer to the device 24 by itself or to the device 24 and the case 28 together. In addition, direct engagement of the lock mechanism 100 with the case 28 can also be considered engagement of the lock mechanism 100 with the device 24.

In the illustrated embodiment, a cord 133 extends from the housing 128. The illustrated cord 133 is a power cord that supplies power to the dock 36 and the portable electronic device 24 through the dock 36. The cord 133 may also or alternatively be a data cable (e.g., a USB cable, an HDMI cable, a network cable, or the like) to provide a data connection to the dock 36 and the portable electronic device 24 through the dock 36. For example, the data cable may input/output audio and/or video from the portable electronic device 24, or the data cable may provide a network connection for the dock 26 and the portable electronic device 24. As shown in Figs. 11 and 12, two ports 134A, 134B are formed in a rear surface of the housing 128. The first port 134A provides a power connection to the dock 36. The second port 134B provides a data connection to the dock 36. In some embodiments, the power and data connections may be integrated into a single port and cord.

The illustrated dock 36 also includes a lock slot 135 formed in the rear surface of the housing 128. Similar to the lock slot 72 (Figs. 2 and 3) formed in the case 28, the lock slot 135 is configured to receive a locking head of a cable lock, such as a MicroSaver® lock sold by Kensington. The cable lock is configured to secure the dock 26 to an immovable object, such as a desk, table, chair, wall, or the like. In some embodiments, the power cord and the cable lock may be combined into a single element that both provides power to the dock 36 and secures the dock 36 in place. In other embodiments, the dock 36 may be secured to an immovable object with fasteners. For example, the dock 36 may be screwed, bolted, and/or glued to a desk or table. In further embodiments, the dock 36 may be mounted to other structures, such as an articulable stand or arm on a desk.

As shown in Figs. 10-12, the illustrated dock 36 includes an elastomeric member 136 and the two guide rails 96 positioned within the slot 132. The elastomeric member 136 is a rubber bar that extends across the slot 132 to engage the case 28. The elastomeric member 136 helps stabilize the case 28 within the slot 132 via a frictional engagement. The guide rails 96 extend into the slot 132 opposite from the elastomeric member 136. The guide rails 96 are spaced apart and are configured to fit within the guide slots 88 (Fig. 3) in the case 28. In the illustrated embodiment, the guide rails 96 are generally T-shaped or dovetail-shaped to inhibit the case 28 from shifting side-to-side and front-to-back within the slot 132. In other embodiments, the guide rails 96 and the guide slots 88 may have other suitable shapes or configurations.

As shown in Figs. 11 and 12, the dock 36 also includes a connector 140 extending from a bottom surface of the slot 132. The connector 140 is configured to extend into the port 68 (Fig. 3) formed in the case 28 to provide power from the dock 36 to the portable electronic device 24 within the case 28. In some embodiments, the connector 140 may be a standard USB connector, a micro USB connector, an HDMI connector, a pogo pin connector, a proprietary connector, or the like. An indicator light 144 (e.g., an LED) is located on the housing 128 to provide a visual indication to a user when the case 28 is properly connected to the dock 36 and the portable electronic device 24 is charging. The illustrated connector 140 is also a data connector. As such, the connector 140 may be used for data synching, audio input and output, video input and output, or the like. In still other embodiments, the dock 36 may include a short-range wireless connector (e.g., a Bluetooth connector) to provide these additional functions.

In the illustrated embodiment, the dock 36 includes an actuator 142 supported by the housing 128 and electrically coupled to the connector 140. The illustrated actuator 142 is a charge and sync button that selectively establishes the power and data connection between the portable electronic device 24 and the dock 36. For example, actuating (e.g., depressing) the actuator 142 will initiate charging and/or data syncing of the portable electronic device 24 while the device 24 is connected to the dock 36; and actuating the actuator 142 again will stop charging and/or data synching the portable electronic device 24.

As shown in Fig. 13, the illustrated dock 36 further includes the lock mechanism 100. The lock mechanism 100 is operable to secure the case 28 within the slot 132 so that the case 28, and thereby the portable electronic device 24, cannot be removed (e.g., pulled out of) the slot 132. In the illustrated embodiment, the lock mechanism 100 includes a hinge plate 148, a solenoid 152, a circuit board 156A-B, and an actuator 160. The hinge plate 148 is pivotally coupled within the housing 128 by a pin 164 and includes two projections 168. The projections 168 selectively extend into the slot 132 and engage the apertures 92 (Fig. 3) on the case 28 to secure the case 28 in place. A biasing member 172 biases the hinge plate 148 toward the slot 132 (i.e., in the direction of arrow A) so that the projections 108 move toward an engaged position with the case 28. In the illustrated embodiment, the biasing member 172 is a coil spring positioned between the hinge plate 148 and a bracket 176. In other embodiments, other suitable biasing members, such as torsion springs positioned around the pin 164, may also or alternatively be employed. Additionally or alternatively, in some embodiments, the lock mechanism 100 may include multiple biasing members to bias the hinge plate 148 toward the engaged position.

In embodiments where the case 28 is omitted and the lock mechanism 100 directly engages the portable electronic device 24, the projections 168 may likewise engage corresponding apertures in the device 24. Alternatively, the projections 168 may be replaced with one or more high-friction pads that engage one or more surfaces of the device 24. In such embodiments, the pads may grip or press on the device 24 to clamp the device 24 within the slot 132 (e.g., between the pads and the elastomeric member 136). In other embodiments, other suitable lock mechanisms 100 that are configured to engage the case 28 and/or the device 24 may also or alternatively be employed.

The solenoid 152 is coupled to the hinge plate 148 and controlled by the circuit board 156A-B. When energized, the solenoid 152 pulls the hinge plate 148 away from the slot 132 against the bias of the biasing member 172 (i.e., in the direction of arrow B) so that the projections 168 move away from and disengage the case 28. As further discussed below, the solenoid 152 is energized when a wireless key 178 (Fig. 9) is within a suitable range of the dock 36 (e.g., within about five feet) and the actuator 160 is actuated. When the solenoid 152 is not actuated, the hinge plate 148 is returned to the engaged position by the biasing member 172 to secure the case 28 in the slot 132. The projections 168 are shaped so that the case 28 can be inserted into the slot 132 without energizing the solenoid 152, but are only moved out of the slot 132 by energizing the solenoid 152.

The circuit board 156A-B is positioned within the housing 128 and electrically coupled between the solenoid 152 and the actuator 160. The circuit board 156A-B includes a processor and a transceiver. In the illustrated embodiment, the circuit board 156A-B is split into two separate boards that communicate with each other. In other embodiments, the circuit board 156A-B may be single board. The circuit board 156A-B receives wireless signals from the wireless key 178 (Fig. 9) via the transceiver to allow operation of the lock mechanism 100. In particular, the processor of the circuit board 156A-B receives the wireless signals from the wireless key 178 when the key 178 is within a suitable range of the dock 36. The processor of the circuit board 156A-B also receives a signal when the actuator 160 is actuated. When the processor receives both types of signals, the processor outputs a signal to energize the solenoid 152, thereby moving the lock mechanism 100 to the disengaged position. In the illustrated embodiment, the circuit board 156A-B is also electrically coupled between the connector 140 and the actuator 142 to control power and data synching between the dock 38 and the portable electronic device 24.

In the illustrated embodiment, the actuator 160 is a button supported by the housing 128. As noted above, the actuator 160 is actuatable by a user to selectively energize the solenoid 152 and move the hinge plate 148 out of engagement with the case 28. After the actuator 160 is actuated (and if the wireless key 178 is within range of the dock 36), the solenoid 152 remains energized for a predetermined period of time (e.g., about five seconds) so that a user can remove the case 28 from the dock 36. In other embodiments, the actuator 160 may be located elsewhere. For example, the actuator 160 may be part of the wireless key 178 (Fig. 9) or part of the portable electronic device 24. In such embodiments, the actuator 160 may be a mechanical button or switch supported by the key 178, the device 24, or the case 28. Alternatively, the actuator 160 may be part of a software program (e.g., a button displayed on the screen 56 of the device 24 or on a screen of the key 178) that is selectively actuated by a user.

The illustrated lock mechanism 100 also includes a mechanical latch release 180. The mechanical latch release 180 is physically coupled to the lock mechanism 100. The mechanical latch release 180 is usable if, for example, the dock 36 is not connected to a power source to properly power the solenoid 152 and the circuit board 156A-B, or if the wireless key 178 is not available. In the illustrated embodiment, the mechanical latch release 180 includes a lock cylinder 184. The lock cylinder 184 is configured to receive a key 188 that is inserted by a user. The user can then rotate the key 188 to actuate the lock cylinder 184 and pivot the hinge plate 148 against the bias of the biasing members 172 so that the projections 168 disengage the case 28. In the illustrated embodiment, a link 192 extends between the lock cylinder 184 and the hinge plate 148 to pull the hinge plate 148 as the lock cylinder 184 rotates. In other embodiments, other suitable mechanical latch releases 180 may alternatively be employed.

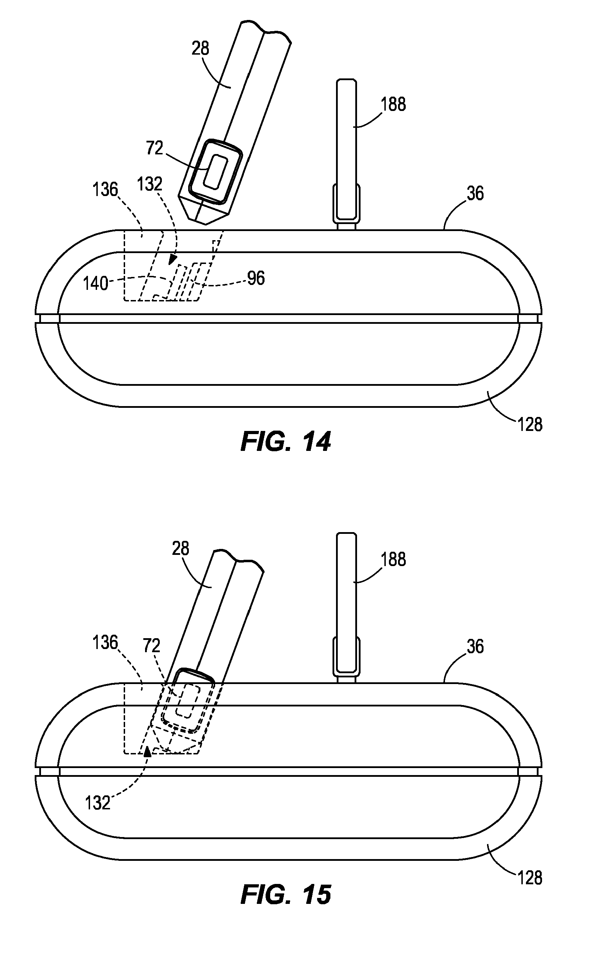

Figs. 14 and 15 illustrate the case 28 being inserted into the slot 132 in the dock 36. As shown in Fig. 14, the case 28 is insertable in a generally downward motion so that the guide slots 88 on the case 28 slide into the guide rails 96 on the dock 36, and so that the projections 168 of the hinge plate 148 extend into the apertures 92 in the case 28. The rails 96 help properly position the case 28 within the slot 132 so that the apertures 92 are properly aligned with the projections 168. Once inserted, as shown in Fig. 15, the case 28 is captured between the elastomeric member 136 and the lock mechanism 100 to secure the case 28, and thereby the portable electronic device 24, to the dock 36.

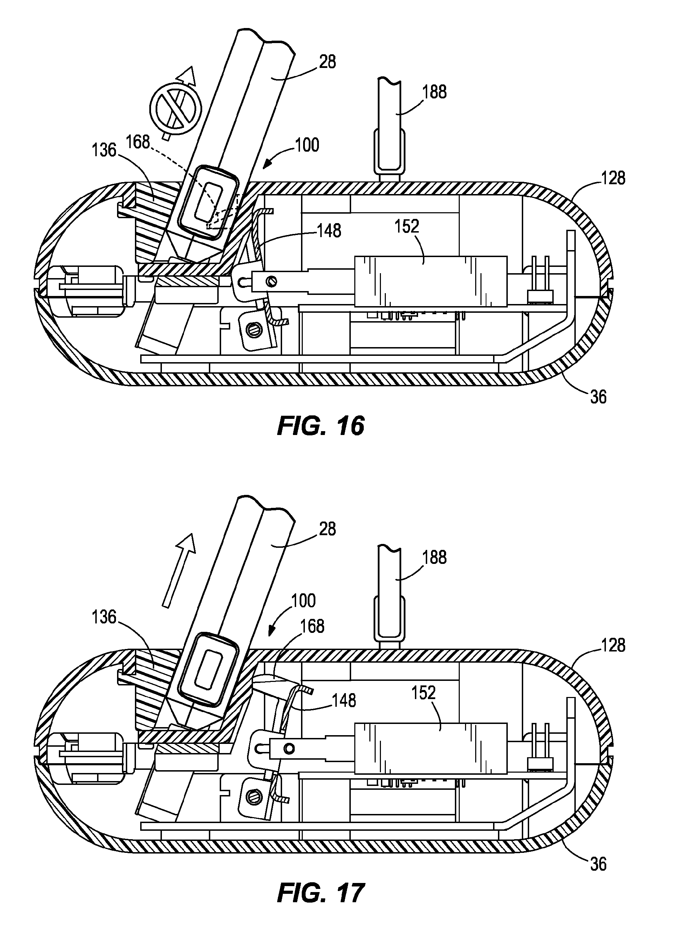

Figs. 16 and 17 illustrate the lock mechanism 100 moving between the engaged position (Fig. 16) and the disengaged position (Fig. 17). In these figures, some of the internal components of the dock 36 are removed to facilitate illustrating the hinge plate 148 and the solenoid 152. When in the engaged position, the solenoid 152 is not energized. In this position, the biasing member 172 biases the projections 168 on the hinge plate 148 into engagement with the case 28. The case 28 and the device 24 are, therefore, secured within the slot 132 of the dock 36. When in the disengaged position, the solenoid 152 is energized. In this position, the solenoid 152 pulls the hinge plate 148 against the bias of the biasing member 172 to pivot the projections 168 away from the case 28 against the bias of the biasing member 172. The case 28 and the device 24 are, therefore, removable from the slot 132 of the dock 36.

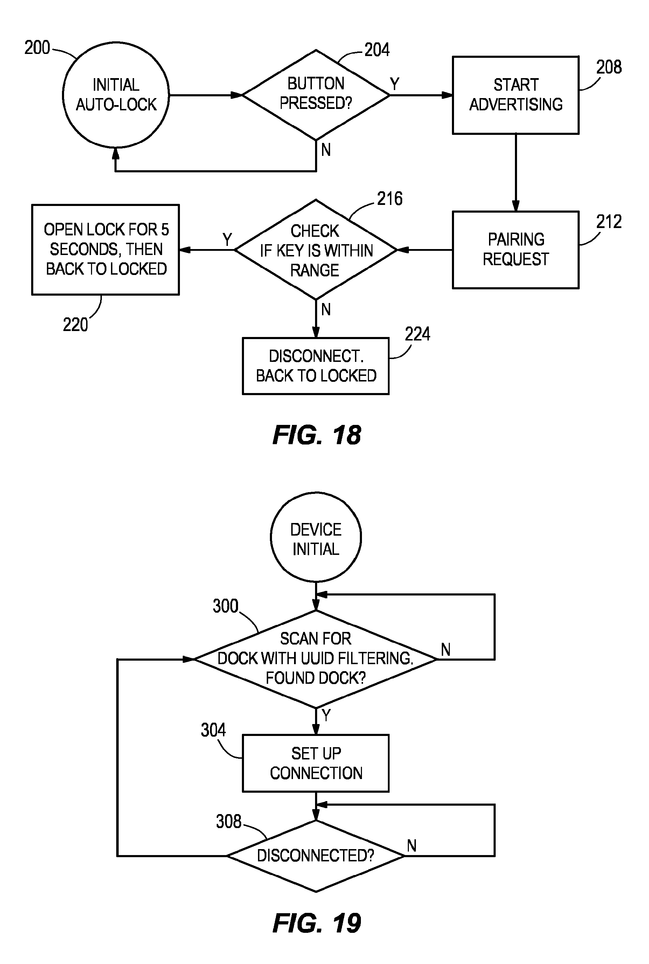

Fig. 18 is a flowchart depicting operation of the logic controlling the lock mechanism 100 in the dock 36. The logic is performed by the printed circuit board 156A-B coupled to the solenoid 152. More particularly, the logic is performed by the processor of the printed circuit board 156A-B. As noted above, the circuit board 156A-B receives signals from the wireless key 178 (Fig. 9). This arrangement is similar to the proximity tag arrangement disclosed in U.S. Patent Application Publication No. 2014/0073262, filed September 12, 2012, the entire contents of which are incorporated by reference herein. The wireless key 178 used to "unlock" the lock mechanism 100 may be a fob, a smartphone, or other apparatus that is capable of transmitting a wireless signal and is carried by a user.

At step 200, the lock mechanism 100 is initially in the engaged or locked position to inhibit the case 28 from being removed from the dock 36. At step 204, the circuit board 156A-B checks whether the actuator 160 has been actuated by a user. If so, the circuit board 156A-B begins searching for the wireless key 178 at steps 208 and 212. The circuit board 156A-B pairs with the wireless key 178 at 212 to verify that the key 178 is authorized to interact with the dock 36. At step 216, if the wireless key 178 is within range and the actuator 160 has been actuated, the solenoid 152 is energized to move the lock mechanism 100 to the disengaged or unlocked position (step 220) so that the case 28 can be removed from the dock 36. The lock mechanism 100 remains in the unlocked position for, for example, about five seconds before returning to the locked position. If the wireless key 178 is not within range, the solenoid 152 is not energized so that the lock mechanism 100 remains in the locked position (step 224).

In other embodiments, the circuit board 156A-B may periodically check whether the wireless key 178 is within range, regardless of whether the actuator 160 has been actuated. In such embodiments, actuating the actuator 160 (while the wireless key 178 is in range) will energize the solenoid 152 to move the lock mechanism 100 to the unlocked position without requiring the circuit board 156A-B to recheck if the key 178 is in range.

Fig. 19 is a flowchart depicting operation of the logic controlling the wireless key 178 that communicates with the dock 36. At step 300, the wireless key 178 periodically scans or searches for the dock 36. If the dock 36 is found, the wireless key 178 establishes a connection (i.e., pairs) with the dock 36 at step 304. Then, the wireless key 178 periodically checks at step 308 if the dock 36 has become disconnected from (e.g., moved out of range of) the wireless key 178. In some embodiments, the dock 36 and/or the wireless key 178 may be programmed to have a range between about five feet and about fifty feet. If the wireless key 178 and the dock 36 become disconnected (i.e., unpaired), the wireless key 178 goes back to step 300 to periodically scan for the dock 36.

Various features and advantages of the invention are set forth in the following claims.

## Claims

1. A system for use with a portable electronic device, the system comprising:
a case including a body configured to receive the portable electronic device, a first attachment structure formed on the body, and a second attachment structure formed on the body;
a folio including a cover and an attachment member, the attachment member engageable with the first attachment structure of the case to selectively attach the case to the folio; and
a dock including a housing and a lock mechanism supported by the housing, the lock mechanism engageable with the second attachment structure of the case to selectively attach the case to the dock.

2. The system of claim 1, wherein the first attachment structure is spaced apart from the second attachment structure.

3. The system of claim 1 or 2, wherein the first attachment structure includes a keyhole-shaped aperture, and wherein a portion of the attachment member of the folio is received in the keyhole-shaped aperture.

4. The system of any of the preceding claims, wherein the second attachment structure includes an aperture, and wherein the lock mechanism includes a projection that is selectively moved into the aperture to secure the case to the dock.

5. The system of claim 4, wherein the second attachment structure further includes a guide slot, and wherein the housing of the dock includes a rail that is received in the guide slot to facilitate aligning the aperture in the case with the projection of the lock mechanism.

6. The system of claim 4 or 5, wherein the dock includes an actuator supported by the housing, and wherein the actuator is operable to move the projection relative to the case.

7. The system of any of the preceding claims, wherein the body of the case includes a front portion and a back portion, wherein the front portion defines an opening through which a screen of the portable electronic device is accessible, and wherein the first and second attachment structures are formed on the back portion.

8. The system of any of the preceding claims, wherein the cover of the folio includes a front cover and a back cover pivotally coupled to the front cover.

9. The system of claim 8, wherein the attachment member of the folio includes a rigid bar coupled to the back cover, and wherein the rigid bar extends across a portion of the case.

10. The system of claim 8 or 9, wherein the front cover and the back cover of the folio are foldable to form a stand for the case.

11. The system of any of the preceding claims, wherein the folio further includes a keyboard that is at least partially supported by the cover.

12. The system of any of the preceding claims, wherein the housing of the dock defines a slot that receives a portion of the case.

13. The system of any of the preceding claims, wherein the dock further includes a connector supported by the housing, and wherein the connector is configured to engage a port of the portable electronic device to electrically connect the portable electronic device to the dock.

14. A case for a portable electronic device, the case comprising:
a body configured to receive the portable electronic device;
a first attachment structure formed on the body, the first attachment structure configured to engage a folio to selectively attach the case to the folio; and
a second attachment structure formed on the body, the second attachment structure configured to engage a dock to selectively attach the case to the dock.

15. The case of claim 14, wherein:
- the first attachment structure is spaced apart from the second attachment structure; and/or
- the body includes a front portion and a back portion, wherein the front portion defines an opening through which a screen of the portable electronic device is accessible, and wherein the first and second attachment structures are formed on the back portion, wherein, preferably, the first attachment structure includes two keyhole-shaped apertures formed in the back portion of the body and/or the second attachment structure includes two apertures formed in the back portion of the body.
